Europäisches Patentamt

European Patent Office

Office européen des brevets

(11) Veröffentlichungsnummer: **0 094 635**
**B1**

(12) **EUROPÄISCHE PATENTSCHRIFT**

(45) Veröffentlichungstag der Patentschrift:
**20.11.86**

(51) Int. Cl.⁴: **H 01 L 41/08**

(21) Anmeldenummer: **83104715.4**

(22) Anmeldetag: **13.05.83**

(54) **Piezoelektrisches Stellglied.**

(30) Priorität: **17.05.82 DE 3218576**

(43) Veröffentlichungstag der Anmeldung:
**23.11.83 Patentblatt 83/47**

(45) Bekanntmachung des Hinweises auf die Patenterteilung:
**20.11.86 Patentblatt 86/47**

(84) Benannte Vertragsstaaten:
**FR GB IT NL SE**

(56) Entgegenhaltungen:
**EP - A - 0 017 921**
**EP - A - 0 050 712**
**US - A - 4 031 418**
**US - A - 4 219 755**

(73) Patentinhaber: **Honeywell Regelsysteme GmbH,
Kaiserleistrasse 55, D-6050 Offenbach am Main (DE)**

(72) Erfinder: **Baumann, Rainer, Kilianstädter Strasse 13,
D-6454 Bruchköbel 2 (DE)**

(74) Vertreter: **Herzbach, Dieter et al, Honeywell Europe S.A.
Holding KG Patent- und Lizenzabteilung
Kaiserleistrasse 55 Postfach 184, D-6050 Offenbach am
Main (DE)**

ACTORUM AG

## Beschreibung

Die vorliegende Erfindung bezieht sich auf ein piezoelektrisches Stellglied nach dem Gattungsbegriff des Anspruches 1. Derartige Stellglieder finden Anwendung in der gesamten Optik, Elektronenmikroskopie, Mikromechanik, bei der Herstellung integrierter Schaltkreise, für Präzisionsventile, in der Ultraschalltechnik usw. Ein besonderer Anwendungsfall ergibt sich bei der Ringlaserkreiseln, wo derartige Stellglieder im Resonatorlängenregler oder auch als Ditherantrieb eingesetzt werden. Diese Stellglieder sollen Stellwege bis 100 µm und Stellkräfte über 20 000 N aufweisen. Sie sollen fernsteuerbar sein und erschütterungsfreie mechanische Verschiebungen gestatten. Hierbei soll die Auflösung höher als $10^{-9}$ m betragen. Ihre Anwendung in einem Hochvakuum soll möglich sein und sie sollen hysterese- und kriechfrei arbeiten. Stellgeschwindigkeiten werden gefordert, die $10^{-2}$ m pro Sek. überschreiten. Auf die Verwendung von Wegaufnehmern soll möglichst verzichtet werden; vielmehr soll der Verschiebeweg dem angelegten elektrischen Signal streng proportional sein.

Eine Einrichtung der gattungsgemässen Art ist grundsätzlich aus der US-A 4 031 418 bekannt, obgleich es sich dort nicht um ein piezoelektrisches Stellglied, sondern um einen piezoelektrischen Schallwandler handelt. Jedoch ist auch dort ein Stapel bestehend aus mehreren aufeinandergestapelten piezokeramischen Scheiben und dazwischen angeordneten Elektroden vorhanden, wobei der Stapel eine zentrale Ausnehmung aufweist und zwischen zwei Körpern eingespannt ist. Die Einspannung des Stapels zwischen den beiden Körpern erfolgt jedoch über eine Bolzenstange völlig starr. Soweit eine Elastizität vorgesehen ist, wird diese durch eine Hülse vorgegeben, die den einen Körper mit einer verstellbaren Gegenmasse verbindet. Der gegenüberliegende Körper dient der Schallabstrahlung. Durch Verstellung der Gegenmasse auf der elastischen Gewindehülse kann die Frequenz geändert werden, mit der der Schallwandler schwingt. Die Schwingung erfolgt hierbei um die Gegenmasse, die somit als ortsfeste Aufhängung dient. Die beiden Körper führen jeweils bei einer Erregung des Piezostapels eine Bewegung aus. Piezoelektrische Stellglieder, die die eingangs genannten Forderungen erfüllen, sind bislang nicht bekannt. Zur Erzeugung einer hohen Stellkraft bei grossem Stellweg werden bislang z.B. piezoelektronische Stapelantriebe verwendet (DE-OS 29 00 609). Bei diesen bekannten Stapelantrieben sind die piezokeramischen Scheiben durch leitfähigen Epoxydklebstoff miteinander verbunden und die Elektroden bestehen aus in den Klebstoff eingebetteten Metallfolien. Bei derart aufgebauten Stapelantrieben ergibt sich eine grosse temperaturabhängige Zusatzverschiebung infolge der hohen Wärmeausdehnung des Epoxydklebstoffs. Ferner sind die Klebstoffeigenschaften selbst stark temperaturabhängig und der Klebstoff besitzt eine mechanische Hysterese infolge seiner teilweisen Plastizität. Klebstoff gast darüber hinaus aus und ist daher nicht für eine Anwendung im Hochvakuum geeignet. Infolge des elastisch-plastischen Verhaltens der Klebstoff-Zwischenschichten in dem Piezostapel werden Stellweg, Stellkraft, Stellgeschwindigkeit, Empfindlichkeit und Auflösung des Stellgliedes stark verringert. Die Klebstoffschichten sind ferner inhomogen und können bei grossen Schwingungsamplituden reissen.

Es ist daher die Aufgabe der vorliegenden Erfindung ein piezoelektrisches Stellglied anzugeben, das bei hoher Stellkraft und grossem Stellweg temperaturunabhängig arbeitet. Die Lösung dieser Aufgabe gelingt gemäss der im Anspruch 1 gekennzeichneten Erfindung. Weitere vorteilhafte Ausgestaltungen der Erfindung sind den Unteransprüchen entnehmbar.

Anhand von in den Figuren der Zeichnung dargestellten Ausführungsbeispielen sei im folgenden die Erfindung näher erläutert.

Es zeigt

Fig. 1 ein Druck-Stellglied für grosse Stellwege;
Fig. 2 ein Zug-Stellglied für grosse Stellwege;
Fig. 3 ein Zug-Stellglied gemäss einer weiteren Ausführungsform für kleinere Stellwege und
Fig. 4 ein gegenüber dem Stellglied in Fig. 3 weiter modifiziertes Zug-Stellglied.

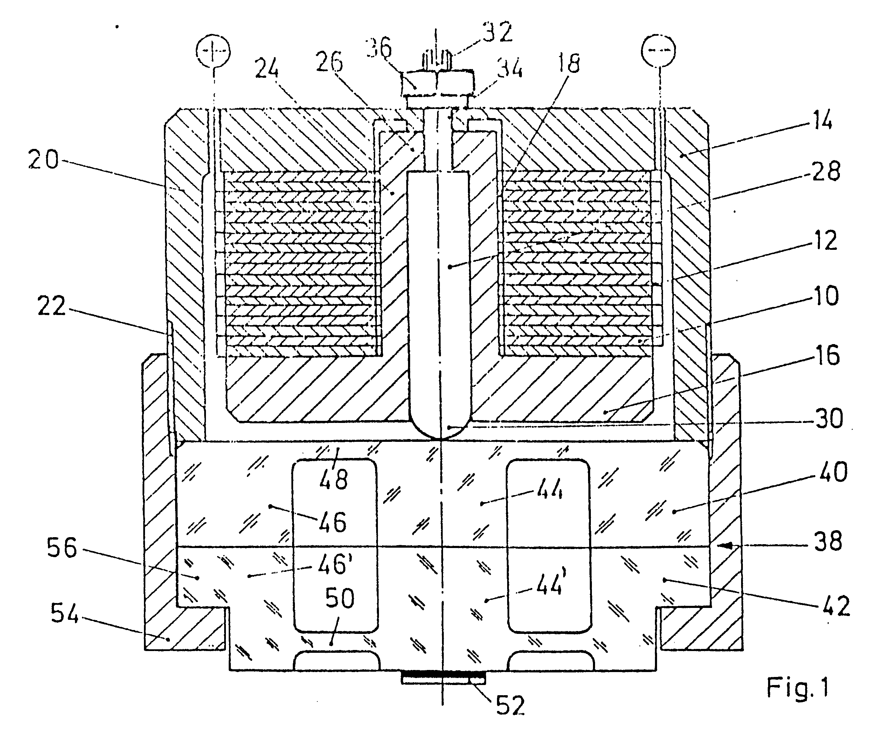

Gemäss Fig. 1 ist ein Stapel aus piezokeramischen Scheiben 10 mit dazwischen angeordneten Elektroden 12 zwischen einer Grundplatte 14 und einer Gegendruckplatte 16 angeordnet. Die piezokeramischen Scheiben 10 und die Elektroden 12 sind mit zentrischen Ausnehmungen 18 versehen. Die Grundplatte 14 geht in eine zylindrische Wand 20 über, die an der Aussenseite mit einem Gewinde 22 versehen ist und den Stapel und die Gegendruckplatte 16 umschliesst. Die Gegendruckplatte 16 besitzt einen nach oben durch die Ausnehmungen 18 ragenden rohrförmigen Ansatz 24. An einer Schulter 26 in dem rohrförmigen Ansatz 24 stützt sich ein als Stössel ausgebildeter Körper 28 ab, der mit seinem Abstützende 30 über die Gegendruckplatte 16 hervorsteht und an diesem Ende kugelförmig abgerundet ist. Der Stössel 28 greift ferner mit seinem oberen Ende, das als Gewindestift 32 ausgebildet ist, durch eine als Bohrung gestaltete Ausnehmung 34 in der Grundplatte 14, wobei die Grundplatte in der Umgebung der Bohrung 34 eine stark reduzierte Dickenabmessung aufweist. Eine Mutter 36 zieht den Stössel 28 gegen die Schulter 26 des rohrförmigen Ansatzes 24, so dass die Gegendruckplatte 16 den Stapel gegen die Grundplatte 14 drückt.

Die Einheit bestehend aus dem topfförmigen Gehäuse der Gegendruckplatte 16 mit dem rohrförmigen Ansatz 24 und dem Stössel 28 und dem dazwischen angeordneten Stapel bildet eine selbständig handhabbare Einheit, wobei der Stapel ohne die Verwendung von Klebstoff durch die federnde mechanische Vorspannung zusammengehalten wird. Die Elektroden 12 sind auf die piezokeramischen Scheiben aufgedampft, aufgesputtert oder eingebrannt und sind über zwischengelegte Metallfolien alternierend miteinander verbunden.

Das Gehäuse und der Stössel 28 werden vorzugsweise aus einem Metall mit vernachlässigbarem thermischen Ausdehnungskoeffizienten gefertigt. Hingegen wird die Gegendruckplatte 16 mit dem rohrförmigen Ansatz 24 aus dem gleichen piezokeramischen Material wie die Scheiben 10 gefertigt, so dass eine temperaturabhängige Längenausdehnung des Piezostapels durch eine entsprechende temperaturabhängige Längenausdehnung der rohrförmigen Ansatzes 24 kompensiert wird.

Der Stössel 28 stützt sich mit seinem kugelförmigen Abstützende 30 auf einem als zweigeteilter Doppelmembran-Zylinder ausgebildeten Element 38 ab.

Dieser Doppelmembran-Zylinder 38 besteht aus zwei rotationssymmetrischen im Schnitt E-förmigen Hälften 40 und 42, wobei sich die drei Stege in optischem Kontakt befinden und durch Adhäsionskräfte zusammengehalten werden. Die Verbindungen zwischen den verbreiterten zentralen Stegen 44, 44' und den ringförmigen Aussenstegen bilden die Ringmembranen 48 und 50. Auf der freien Fläche des unteren zentralen Steges 44' ist ein dielektrischer Mehrschichtspiegel 52 aufgebracht. Der Doppelmembran-Zylinder 38 besteht aus Glaskeramik und bildet ein durch den Stapelantrieb parallel verschiebbares Element, wie es als Resonatorlängenregler bei Ringlaserkreiseln Anwendung findet.

Mittels einer Schraubkappe 54, die mit einem Innengewinde in das Gewinde 22 an der zylindrischen Wand 20 eingreift und einen Ringflansch 56 der oberen oder unteren Hälfte 40 bzw. 42 überstellt, wird der Doppelmembran-Zylinder 38 gegen den Stössel 28 gezogen.

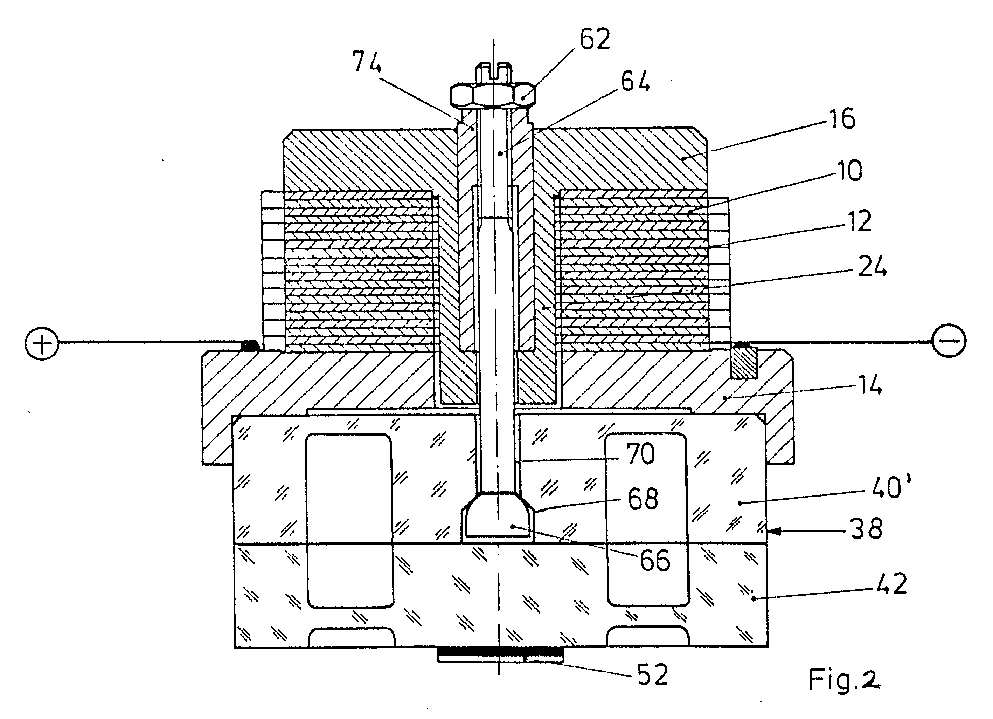

Bei dem Zug-Stellglied gemäss Fig. 2 haben im wesentlichen die Grundplatte 14 und die Gegendruckplatte 16 ihre Lage vertauscht, und es ist eine Zugstange 64 angeordnet, die mit einem als Kugelkopf ausgebildeten Abstützende 66 an der oberen Hälfte 40' des Doppelmembran-Zylinders 38 angreift. Die obere Hälfte 40' des Doppelmembran-Zylinders ist dementsprechend mit einer Ausnehmung 68 und einer zentralen Bohrung 70 versehen. Die Zugstange 64 weist in ihrem oberen Bereich ein Gewinde auf, mit welchem eine sich in dem rohrförmigen Ansatz 24 abstützende Gewindehülse 74 zusammenwirkt, um die Vorspannung für den Stapel einzustellen. Die Feder ist hierbei durch den Doppelmembran-Zylinder 38 vorgegeben. Die Kontermutter 62 sichert die Gewindhülse 74.

Im vorliegenden Ausführungsbeispiel ist der zwischen der Grundplatte 14 und der Gegendruckplatte 16 eingespannte Piezostapel nicht selbständig handhabbar; vielmehr bedarf es des Doppelmembran-Zylinders 38, um den Piezostapel federnd vorzuspannen (integrierte Bauweise).

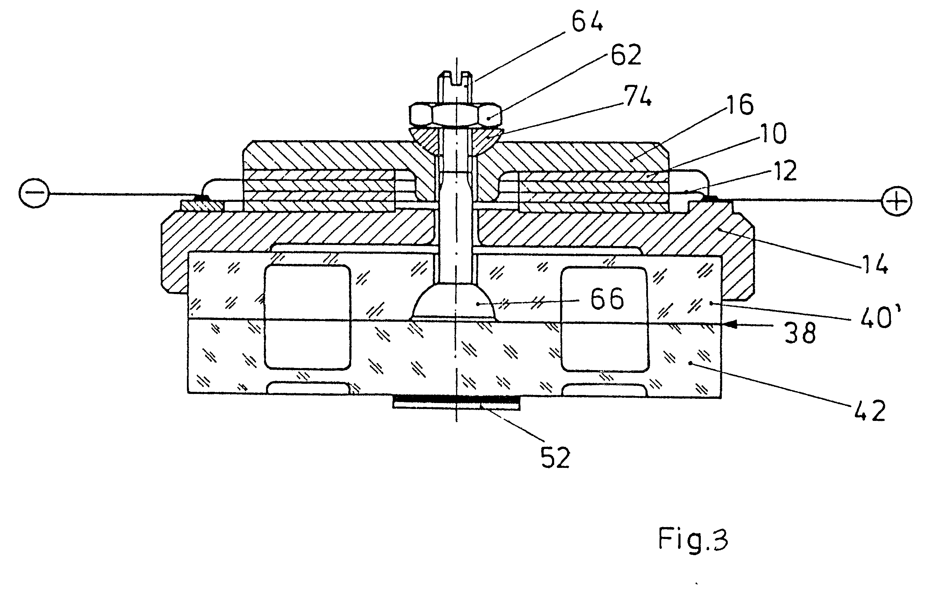

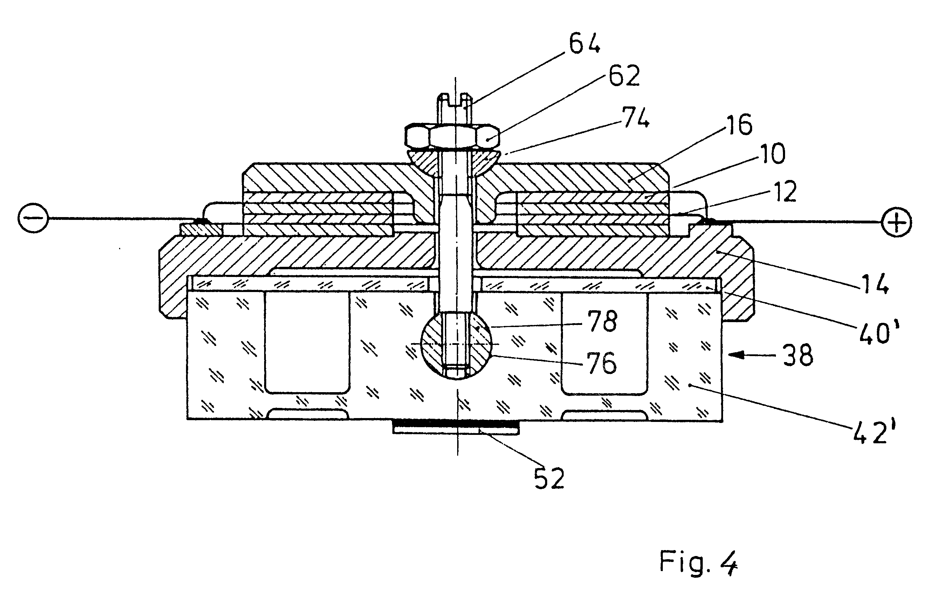

Die Zug-Stellglieder gemäss den Fig. 3 und 4 unterscheiden sich von demjenigen gemäss Fig.

2 wiederum im wesentlichen durch einen Piezostapel geringerer Bauhöhe und einen daraus resultierenden Verzicht auf eine exakte passive Wärmeausdehnungskompensation. Durch Auswahl eines geeigneten Metalls für die Zugstange 64 erzielt man eine grobe passive Wärmeausdehnungskompensation. Ferner ist bei diesem Ausführungsbeispiel eine Doppelgelenkabstützung der Zugstange 64 vorgesehen.

Gemäss Fig. 3 stützt sich eine halbkugelförmige Vorspannmutter 74 in einer entsprechend geformten zentralen Ausnehmung in der Gegendruckplatte 16 ab und das Gewinde der Zugstange 64 durchsetzt diese Vorspannmutter. Die Vorspannmutter 74 zieht die Gegendruckplatte 16 federnd gegen den Piezostapel, wobei wiederum der Doppelmembran-Zylinder 38 die Federkraft vorgibt. Die Kontermutter 62 sichert hierbei die halbkugelförmige Vorspannmutter 74.

Während bei den Ausführungsbeispielen gemäss den Fig. 2 und 3 der optische Kontakt zwischen beiden Hälften 40' und 42 des Doppelmembran-Zylinders 38 auf Zug beansprucht wird, zeigt Fig. 4 ein Ausführungsbeispiel, bei dem der optische Kontakt auch bei einem Zug-Stellglied lediglich auf Druck beansprucht wird.

Hierzu bedarf es einer Abänderung der unteren Hälfte 42' des Doppelmembran-Zylinders 38 dergestalt, dass der Zerodurzylinder diametral von der Seite mit einer Bohrung 76 versehen wird. In diese Bohrung 76 wird eine Kugel- bzw. Zylindermutter 78 eingesetzt, in die die Zugstange 64 von oben eingeschraubt wird. Die obere Hälfte besteht hier aus einer Platte 40', die durch optischen Kontakt oder Golddiffusion mit der unteren Hälfte 42' starr verbunden ist.

## Patentansprüche

1. Piezoelektrisches Stellglied, bestehend aus einem Stapel mit mehreren aufeinandergestapelten piezokeramischen Scheiben (10) und dazwischen angeordneten Elektroden (12), wobei der Stapel eine zentrale Ausnehmung (18) aufweist und zwischen zwei Körpern (14, 16) eingespannt ist, dadurch gekennzeichnet, dass der eine Körper durch eine ortsfeste Grundplatte (14) und der andere Körper durch eine bewegliche Gegendruckplatte (16) vorgegeben ist, wobei die Gegendruckplatte (16) mit einem zentralen Ansatz und/oder einer Zugstange (24, 28, 64) durch die Ausnehmung (18, 34) hindurchragt und sich an einem federnden Element (38) abstützt, welches sich parallel zur Grundplatte (14) erstreckt und in bezug auf diese eine Vorspannung aufweist, um einerseits den lose geschichteten Stapel zu verspannen und andererseits durch eine temperaturbedingte Ausdehnung des Ansatzes und/oder der Zugstange die temperaturbedingte Ausdehnung des Stapels zu kompensieren.

2. Stellglied nach Anspruch 1, dadurch gekennzeichnet, dass die Elektroden (12) lose zwischen die piezokeramischen Scheibe (10) eingelegt sind.

3. Stellglied nach Anspruch 1, dadurch gekennzeichnet, dass die Elektroden (12) in spezieller Formgebung auf die piezokeramischen Scheiben (10) aufgebracht sind.

4. Stellglied nach Anspruch 1, dadurch gekennzeichnet, dass das federnde Element durch eine verschiebbare Einrichtung (38) gebildet wird.

5. Stellglied nach Anspruch 4, dadurch gekennzeichnet, dass sich die Gegendruckplatte (16) mittels eines sphärischen Körpers (30, 66, 78) an der verschiebbaren Einrichtung (38) abstützt.

6. Stellglied nach Anspruch 1, dadurch gekennzeichnet, dass der Ansatz als Rohransatz (24) ausgebildet ist und dass in dem Rohransatz ein sich an dem federnden Element (38) abstützender Körper (28) gehalten ist.

7. Stellglied nach Anspruch 6, dadurch gekennzeichnet, dass der Rohransatz (24) aus dem gleichen Material wie die piezokeramischen Scheiben (10) des Stapels besteht.

8. Stellglied nach Anspruch 6, dadurch gekennzeichnet, dass der in dem Rohransatz (24) gehaltene Körper (28) von der verschiebbaren Einrichtung (38) auf Druck oder Zug beanspruchbar ist.

9. Stellglied nach Anspruch 4, dadurch gekennzeichnet, dass die verschiebbare Einrichtung aus einem Doppelmembran/Zylinder (38) besteht.

10. Stellglied nach Anspruch 9, dadurch gekennzeichnet, dass der Doppelmembran/Zylinder (38) zweigeteilt ist und beide Hälften miteinander verbunden sind.

11. Stellglied nach Anspruch 10, dadurch gekennzeichnet, dass der Doppelmembran/Zylinder (38) aus Glaskeramik besteht und sich beide Hälften in optischem Kontakt befinden bzw. durch ein Golddiffusionsverfahren miteinander verbunden sind.

12. Stellglied nach einem der Ansprüche 1 bis 11, gekennzeichnet durch die Verwendung eines hysterese- und kriechfreien Materials für die piezokeramischen Scheiben (10) bzw. die Gegendruckplatte (16) mit Rohransatz (24).

13. Stellglied nach Anspruch 6, dadurch gekennzeichnet, dass die Grundplatte (14) und der Abstützkörper (28) aus Material mit vernachlässigbarem Temperatur-Ausdehnungskoeffizienten (Super-Invar) bestehen.

14. Stellglied nach Anspruch 6, dadurch gekennzeichnet, dass der Grundplattentopf (14) bzw. die Zugstange (64) aus einem ausgewählten Metall bestehen und eine zu dem Piezostapel gegenläufige Temperaturausdehnung ausführen.

15. Stellglied nach Anspruch 10, dadurch gekennzeichnet, dass der Doppelmembran/Zylinder (38) aus Metall besteht und beide Hälften miteinander verschraubt oder verschweisst sind.

## Claims

1. Piezoelectric regulating unit comprising a stack consisting of a plurality of piled-up piezoceramic disks (10) and intermediately arranged electrodes (12), whereat the stack comprises a central opening (18) and is biased between two bodies (14, 16), characterized in that one of said bodies is provided by a stationary base plate (14) and the other body is provided by a movable counterpressure plate (16), whereat the counterpressure plate (16) extends with a central extension and/or a pull rod (24, 28, 64), respectively, through said opening (18, 34) and abuts against a resilient element (38), which extends parallel to said base plate (14) and is biased with respect to said plate in order to load at one hand said loosely piled-up stack and to compensate at the other hand an expansion of said stack by an expansion of said extension and/or pull rod due to temperature changes.

2. Regulating unit according to claim 1, characterized in that the electrodes (12) are loosely inserted between said piezoceramic disks (10).

3. Regulating unit according to claim 1, characterized in that the electrodes (12) with a special shape are surfacing said piezoceramic disks (10).

4. Regulating unit according to claim 1, characterized in that the resilient element is formed by a displaceable device (38).

5. Regulating unit according to claim 4, characterized in that the counterpressure plate (16) via a spherical body (30, 66, 78) abuts against the displaceable device (38).

6. Regulating unit according to claim 1, characterized in that the extension is formed as a tube extension and that a body (28) is fixed within said tube extension which abuts against said resilient element.

7. Regulating unit according to claim 6, characterized in that the tube extension (24) consists of the same material as the piezoceramic disks (10) of the stack.

8. Regulating unit according to claim 6, characterized in that the body (28) fixed in said tube extension (24) is loaded by said displaceable device (38) by a compression or tensile force, respectively.

9. Regulating unit according to claim 4, characterized in that the displaceable device consists of a double diaphragm/cylinder (38).

10. Regulating unit according to claim 9, characterized in that the double diaphragm/cylinder (38) comprises two halves and that both halves are connected to each other.

11. Regulating unit according to claim 10, characterized in that the double diaphragm/cylinder (38) consists of glass ceramics and both halves are in optical contact or are connected to each other by a gold diffusion process, respectively.

12. Regulating unit according to one of claims 1 to 11, characterized by the use of creepage and hysteresis-proof materials for the piezoceramic disks (10) and the counterpressure plate (16) with the tube extension (24), respectively.

13. Regulating unit according to claim 6, characterized in that the base plate (14) and the abutting body (28) consist of a material having a disregardable temperature coefficient of expansion (Super-Invar).

14. Regulating unit according to claim 6, characterized in that the base plate (14) or the pull rod (64), respectively, consist of a selected metal enabling them to make a temperature responsive expansion opposite to said piezo stack.

15. Regulating unit according to claim 10, characterized in that the double diaphragm/cylinder (38) consists of metal and both halves are screwed or welded together, respectively.

## Revendications

1. Organe de réglage piézoélectrique constitué par un empilement de plusieurs disques (10) piézocéramiques empilés les uns sur les autres et par des électrodes (12) disposées entre ces derniers, l'empilement comportant un évidement central (18) et étant serré entre deux corps (14, 16), caractérisé en ce que l'un des corps est constitué par une plaque de base fixe (14) et l'autre coprs par une plaque de contre-pression mobile (16), la plaque de contre-pression (16) faisant saillie avec un appendice central et/ou un tirant (24, 28, 64) à travers l'évidement (18, 34) et étant en appui sur un élément élastique (38) qui s'étend parallèlement à la plaque de base (14) et qui est précontraint par rapport à cette dernière pour serrer d'une part l'empilement de disques empilés librement et pour compenser d'autre part la dilatation thermique de l'empilement par une dilatation thermique de l'appendice et/ou du tirant.

2. Organe de réglage selon la revendication 1, caractérisé en ce que les électrodes (12) sont disposées librement entre les disques piézocéramiques (10).

3. Organe de réglage selon la revendication 1, caractérisé en ce que les électrodes (12) sont appliquées sous une forme particulière sur les disques piézocéramiques (10).

4. Organe de réglage selon la revendication 1, caractérisé en ce que l'élément élastique est constitué par un dispositif mobile (38).

5. Organe de réglage selon la revendication 4, caractérisé en ce que la plaque de contre-pression (16) s'appuie sur le dispositif mobile (38) au moyen d'un corps sphérique (30, 66, 78).

6. Organe de réglage selon la revendication 1, caractérisé en ce que l'appendice est un appendice de forme tubulaire (24) et qu'un corps (28) en appui sur l'élément élastique (38) est maintenue dans l'appendice tubulaire.

7. Organe de réglage selon la revendication 6, caractérisé en ce que l'appendice tubulaire (24) consiste en le même matériau que les disques piézocéramiques (10) de l'empilement.

8. Organe de réglage selon la revendication 6, caractérisé en ce que le corps (28) maintenu dans l'appendice tubulaire (24) peut être sollicité en compression ou en traction par le dispositif mobile (38).

9. Organe de réglage selon la revendication 4, caractérisé en ce que le dispositif mobile est constitué par un vérin à double membrane (38).

10. Organe de réglage selon la revendication 9, caractérisé en ce que le vérin à double membrane (38) est en deux parties et que les deux moitiés sont reliées ensemble.

11. Organe de réglage selon la revendication 10, caractérisé en ce que le vérin à double membrane (38) est un vitrocéramique et que les deux moitiés se trouvent en contact optique et/ou sont reliées ensemble par un procédé de diffusion aurique.

12. Organe de réglage selon l'une des revendications 1 à 11, caractérisé par l'utilisation d'un matériau sans hystérésis et sans fluage pour les disques piézocéramiques (10) et/ou la plaque de contre-pression (16) avec l'appendice tubulaire (24).

13. Organe de réglage selon la revendication 6, caractérisé en ce que la plaque de base (14) et le corps d'appui (28) consistent en un matériau ayant un coefficient de dilatation thermique négligeable (super invar).

14. Organe de réglage selon la revendication 6, caractérisé en ce que la plaque de base (14) et/ou le tirant (64) consistent en un métal choisi et ont une dilatation thermique contraire à l'empilement piézoélectrique.

15. Organe de réglage selon la revendication 10, caractérisé en ce que le vérin à double membrane (38) est en métal et que les deux moitiés sont vissées ou soudées ensemble.

Fig.1

Fig. 2

74 62 64 16 10 12 24 14 40' 38 42 70 68 66 52

0 094 635

Fig.3

0 094 635

Fig. 4

0 094 635